# FASCICULE DE BREVET EUROPEEN

(11) **EP 2 104 238 B1**
(45) Date de publication et mention de la délivrance du brevet: **19.07.2017**
(21) Numéro de dépôt: 09154916.2
(22) Date de dépôt: 11.03.2009
(51) Int. Cl.: H04B 1/30, H03C 3/40, H04L 27/36

(54) **DISPOSITIF PERMETTANT DE MODULER UN SIGNAL ANALOGIQUE DANS UNE LARGE BANDE DE FRÉQUENCE À PARTIR D'UN SIGNAL NUMÉRIQUE DE MODULATION**
VORRICHTUNG ZUM MODULIEREN EINES ANALOGEN SIGNALS IN EINER BREITBANDFREQUENZ DURCH EIN DIGITALMODULATIONSSIGNAL
APPARATUS FOR MODULATING AN ANALOG SIGNAL IN A FREQUENCY WIDEBAND WITH A DIGITAL MODULATION SIGNAL

(30) Priorité: 21.03.2008 FR 0801578
(43) Date de publication de la demande: 23.09.2009
(73) Titulaire: Thales, 92400 Courbevoie (FR)
(72) Inventeur: Veryeras, Alexandre, 78180, MONTIGNY-LE-BRETONNEUX (FR); Passelaigue, Daniel, 78580, MAULE (FR); Autrusson, Bernard, 92290, CHATENAY MALABRY (FR)
(74) Mandataire: Lucas, Laurent Jacques

(56) Documents cités:
- WO-A-00/59171
- TREYER D M ET AL: "INVESTIGATION OF A SELF-CALIBRATING SSB MODULATOR" IEEE TRANSACTIONS ON MICROWAVE THEORY AND TECHNIQUES, IEEE SERVICE CENTER, PISCATAWAY, NJ, US, vol. 53, no. 12, 1 décembre 2005 (2005-12-01), pages 3806-3816, XP001240895 ISSN: 0018-9480

## Description

La présente invention concerne un dispositif permettant de moduler, avec une grande pureté spectrale, un signal analogique dans une large bande de fréquence à partir d'un signal numérique de modulation. Elle peut s'appliquer par exemple dans tous les domaines où un signal analogique doit être modulé numériquement, que ce soit en amplitude ou en phase.

Les télécommunications et les radars nécessitent souvent de synthétiser numériquement des signaux radiofréquences dans une large bande de fréquence avec une très haute pureté spectrale. Les signaux radiofréquence en question peuvent avoir des formes d'ondes extrêmement variées. Et en fonction des domaines d'utilisation, qui peuvent aller des émetteurs de télécommunication aux radars bande X par exemple, les signaux radiofréquence en question peuvent être portés par n'importe quelle fréquence analogique.

Dans les systèmes radioélectriques actuels, les choix d'architecture sont essentiellement guidés par la nature des modulations, par les gammes de radiofréquences ciblées ainsi que par les besoins en terme de pureté spectrale. Les systèmes actuels utilisent souvent le principe de génération du signal sur une fréquence porteuse intermédiaire. Par exemple, la synthèse numérique directe sur fréquence porteuse intermédiaire basse en bande étroite, suivie d'un ou plusieurs étages analogiques de transposition de fréquence, offre une bonne pureté spectrale dans une gamme de radiofréquence donnée. Mais elle offre une faible largeur de bande de modulation. Autre exemple, la synthèse de fréquence indirecte par transposition puis multiplication de fréquence d'une synthèse numérique directe sur fréquence porteuse intermédiaire basse, offre une large bande de modulation dans une gamme de radiofréquence donnée. Mais elle offre une pureté spectrale dégradée à cause de la multiplication de fréquence. Autre exemple encore, la synthèse indirecte par boucle à verrouillage de phase permettant d'effectuer une multiplication de la fréquence issue d'une synthèse numérique directe sur fréquence porteuse intermédiaire basse. Cette technique permet de couvrir une large gamme de radiofréquences, mais elle n'offre qu'une bande de modulation limitée, un temps de réponse élevé et une pureté spectrale dégradée à cause de la multiplication.

Il existe aussi des générateurs numériques permettant de produire des formes d'ondes arbitraires, c'est-à-dire représentant un signal qui ne suit aucune loi mathématique en amplitude ou en phase. Ces générateurs comportent notamment une mémoire de type RAM pour stocker une forme d'onde arbitraire téléchargée. La mémoire est lue par un composant numérique de type « FPGA » par exemple, selon l'acronyme anglo-saxon signifiant « Field-Programmable Gate Array », qui joue le rôle d'interface entre la mémoire de formes d'ondes et des convertisseurs numériques-analogiques. L'ensemble constitue un générateur numérique de formes d'ondes. Un convertisseur numérique-analogique, qui sera désigné par l'acronyme « CNA » par la suite, permet de convertir le signal de sortie du module numérique en signal analogique. Mais en l'état actuel des technologies, ces générateurs sont limités à des gammes de fréquences basses et à des bandes étroites de modulation.

Certains générateurs numériques de formes d'ondes arbitraires utilisent un mélangeur à bande latérale unique, qui sera appelé « mélangeur BLU » par la suite, afin de transposer la modulation autour d'une fréquence porteuse d'oscillation. Mais les défauts du mélangeur introduisent des écarts entre le signal analogique modulé obtenu en pratique après conversion et la modulation théorique de la fréquence porteuse par le signal numérique de modulation. Cela concerne notamment la fuite d'oscillateur local, qui sera appelée « fuite OL » par la suite, la présence de la raie image et la présence de raies dites d'intermodulations. C'est pourquoi certains générateurs utilisant un mélangeur BLU comportent également un mécanisme de compensation en boucle ouverte visant à compenser les défauts du mélangeur par des valeurs préréglées fixes ou tabulées, sans chaîne de mesure et de compensation dynamique des défauts du mélangeur BLU. Mais une compensation par des valeurs fixes ou tabulées ne permet pas d'annuler les défauts du BLU, seulement de les atténuer. Du coup, la pureté spectrale obtenue en sortie du générateur n'est pas bonne, au mieux -50dBc sur une gamme de température et de fréquence étendue.

D'autres générateurs utilisant un mélangeur BLU comportent un mécanisme de correction en boucle fermée. Certains comportent un amplificateur de puissance en sortie du mélangeur BLU, l'amplificateur permettant d'émettre une onde radioélectrique via une antenne. Le retour de boucle se fait en sortie de l'amplificateur, il est assuré par un récepteur suivi d'un convertisseur analogique-numérique, qui sera désigné par l'acronyme « CAN » par la suite. Le signal de retour de boucle est fourni à un module numérique de calcul qui corrige les défauts de non-linéarité de la chaîne d'émission, notamment les défauts de l'amplificateur. Mais une telle structure vise à corriger les défauts de linéarité de la chaîne d'émission, notamment ceux de l'amplificateur de puissance. La correction ne porte pas spécifiquement sur la qualité spectrale de la modulation issue du mélangeur BLU. Les défauts du mélangeur BLU, à savoir la fuite OL, la raie image et les raies d'intermodulation ne sont pas corrigés à des fins de synthèse de forme d'onde à haute pureté spectrale.

Le brevet américain US 6 931 343 B2 divulgue un générateur utilisant un mélangeur BLU et comportant un mécanisme de correction en boucle fermée, le retour de boucle se faisant directement en sortie du mélangeur BLU. Dans ce brevet, le retour de boucle est assuré par un détecteur d'enveloppe suivi d'un CAN. Cette technique est limitée par la faible dynamique de mesure d'amplitude du détecteur d'enveloppe. Ainsi la correction des défauts du mélangeur BLU est limitée par la capacité du système à observer les défauts en amplitude. De plus, la chaîne de mesure ainsi constituée est peu sélective en fréquence : elle ne permet pas de dissocier distinctement les défauts du mélangeur à mesurer. De plus, le système homodyne analogique de retour de boucle formé par le détecteur d'enveloppe et le CAN offre une faible dynamique de mesure, ceci parce-que le CAN utilisé ne permet de mesurer que des signaux variant lentement. Et plus la bande de modulation en sortie du mélangeur BLU s'élargit, moins le CAN offre une bonne dynamique de mesure. Ainsi, en bande de modulation étroite, la pureté spectrale est bonne. Mais la pureté spectrale diminue rapidement quand la bande de modulation s'élargit. Finalement, le générateur divulgué dans le brevet américain US 6 931 343 B2 permet seulement de corriger de façon préférentielle les défauts du mélangeur les plus gênants, ceci avec une faible dynamique et sur une bande de modulation étroite

Il apparaît clairement que les générateurs actuels de radiofréquences, sans chaîne de retour ni mélangeur BLU, sont très souvent dédiés à une forme d'onde, notamment une fréquence porteuse et une largeur de bande. Leurs architectures nécessitent à chaque fois des adaptations spécifiques et complexes en fonction des besoins, notamment en terme de pureté spectrale. Lorsque des mélangeurs BLU sont utilisés, le procédé de correction des défauts mis en oeuvre, également appelé procédé de calibrage, ne concerne pas toujours le mélangeur BLU. Et lorsque le mélangeur BLU est concerné par le calibrage, la correction apportée est limitée en dynamique, en bande de modulation et en nombre de raies traitées. La correction est également sensible aux variations de l'environnement, notamment la température et la fréquence de modulation Il s'agit là de l'un des problèmes techniques que la présente invention se propose de résoudre.

L'invention a notamment pour but de pallier les inconvénients précités, en séparant la génération de la modulation de la génération de la fréquence porteuse de la modulation. A cet effet, l'invention a pour objet un dispositif permettant de moduler un signal analogique dans une large bande de fréquence à partir d'un signal numérique de modulation. Le dispositif comporte, disposés en boucle fermée :
- un mélangeur à bande latérale unique fournissant en sortie le signal analogique modulé ;
- un récepteur radio-fréquences recevant en entrée le signal analogique modulé de retour de boucle ;
- un convertisseur analogique-numérique recevant en entrée la sortie analogique du récepteur radio-fréquences ;
- un module numérique de calcul recevant en entrée le signal numérique de modulation et la sortie numérique du convertisseur analogique-numérique, ledit module calculant des signaux numériques qu'il fournit en entrée de convertisseurs numérique-analogiques, chacun desdits convertisseurs fournissant un signal analogique à l'une des entrées du mélangeur, lesdits signaux numériques étant calculés de sorte à corriger les écarts introduits par le mélangeur dans le signal analogique modulé par rapport au signal numérique de modulation ;
- des moyens pour transposer le signal analogique modulé dans la bande de mesure du convertisseur analogique-numérique par sous-bandes de fréquence, de sorte que le convertisseur analogique-numérique mesure les écarts introduits par le mélangeur quelle que soit la gamme de fréquence dans laquelle le signal analogique est modulé.

Dans un mode de réalisation, chacun des convertisseurs numérique-analogiques peut fournir un signal analogique à l'une des entrées du mélangeur par l'intermédiaire d'un étage analogique vidéofréquence.

Avantageusement, le récepteur radio-fréquences peut être à linéarité élevée, dynamique élevée et rapport signal à bruit élevé.

Dans un mode de réalisation, les moyens pour transposer le signal analogique modulé peuvent comporter une boucle à verrouillage de phase dont le taux de multiplication est ajustable, permettant de sélectionner une sous bande de fréquence en sélectionnant sa fréquence centrale.

Dans un mode de réalisation, l'entrée OL du mélangeur peut être alimentée par une boucle à verrouillage de phase dont le taux de multiplication est ajustable, permettant de sélectionner une fréquence porteuse du signal analogique modulé.

Dans un mode de réalisation, le récepteur radio-fréquence peut comporter au moins un filtre passe-bande, permettant au convertisseur analogique-numérique de mesurer une sous-bande de fréquence du signal analogique modulé.

Avantageusement, les signaux en entrée du mélangeur peuvent être des signaux vidéofréquences en quadrature à couplage continu ne dépendant pas de la sous-bande de fréquence sélectionnée à un instant donné.

Avantageusement, le module numérique de calcul peut être implémenté dans un FPGA qui lit le signal numérique de modulation dans une mémoire, de sorte que le dispositif peut générer des formes d'ondes arbitraires. Il peut également être implémenté dans un FPGA qui calcule le signal numérique de modulation en utilisant des opérateurs de traitement de signal numérique. Les moyens pour transposer le signal analogique modulé peuvent être commandés par le module numérique de calcul.

Avantageusement, la fréquence d'échantillonnage du convertisseur analogique-numérique peut être inférieure ou égale à la fréquence d'échantillonnage des convertisseurs numérique-analogiques, de sorte que le convertisseur analogique-numérique mesure, dans une sous-bande de fréquence donnée, une fuite d'oscillateur local, une raie image et des raies d'intermodulation introduites par le mélangeur. Le module numérique de calcul peut ainsi annuler, dans le signal analogique modulé la fuite d'oscillateur local, la raie image et les raies d'intermode.

L'invention a encore pour principaux avantages que l'utilisation d'une mémoire pour stocker les formes d'ondes permet de générer des formes d'ondes totalement arbitraires, avec un contrôle total de la phase et de l'amplitude du signal radiofréquence synthétisé. Cette capacité permet de faire face à tous les besoins de modulation connus à ce jour, sans avoir à changer l'architecture du générateur numérique. C'est pourquoi la partie de génération de la modulation n'a jamais besoin d'évoluer. En cas de changement de la bande radiofréquence de travail, il suffit uniquement d'adapter la partie de génération de la fréquence porteuse et la chaîne de retour. Les caractéristiques de haute pureté spectrale sont conservées grâce à la correction en boucle fermée. L'invention permet également de travailler à partir d'un signal numérique de très large bande de modulation en phase et en amplitude, élaboré par calcul dans un composant logique programmable de type FPGA par exemple. L'invention permet, par l'utilisation de deux CNA connectés au mélangeur BLU par l'intermédiaire d'un étage analogique de type vidéofréquence, d'optimiser l'utilisation de la bande analogique disponible à la sortie des CNA comparativement à une synthèse numérique classique sur fréquence intermédiaire avec un seul CNA. Cette optimisation permet de délivrer jusqu'à 4 fois plus de bande de modulation par CNA qu'une solution classique. De plus, l'invention permet d'utiliser les CNA dans des plages de fréquence plus basses que ne le font les synthèses sur fréquence intermédiaire. Ceci permet d'utiliser les CNA dans les domaines de fréquence où leur pureté spectrale est optimum.

L'invention permet également de couvrir continûment de très larges domaines de fréquence, typiquement plusieurs GHz. En pratique, la génération de la porteuse est dite agile, c'est-à-dire que la fréquence porteuse délivrée peut être variable par pas de fréquence élémentaires programmables. Ces pas sont alors choisis légèrement inférieurs à la bande instantanée du générateur de modulation afin de permettre un recouvrement des bandes de fréquences. Le générateur ainsi constitué possède alors les propriétés de l'invention, mais avec en plus une bande de fréquence couverte élargie et un fonctionnement par sous bandes de fréquence sélectionnées par agilité de la génération de la porteuse. Une version ultime de ce principe, pour les applications très large bande de fréquence, consiste à généraliser ce principe mais avec plusieurs mélangeurs BLU, chaque mélangeur étant associé à une chaîne de retour. A un instant donné, un seul mélangeur BLU est utilisé pour une fréquence centrale donnée autour de laquelle est développée la bande instantanée du générateur numérique. Par ailleurs, en séparant la génération de la modulation, source de raies parasites, de la génération de la fréquence porteuse, qui amène le bruit de phase, l'invention permet également de séparer les contributeurs et ainsi de minimiser le bruit de phase. En effet, le bruit de phase à la sortie des CNA est plus élevé qu'à la sortie d'un oscillateur analogique de référence, par exemple un oscillateur à quartz. Dans les structures conventionnelles, le bruit de phase en sortie des CNA est un contributeur non négligeable au bruit de phase du système et c'est ce bruit qui est amplifié par multiplication Dans la présente invention, les écarts de fréquence entre les signaux modulants issus des CNA et la porteuse sont très grands. La contribution en bruit des CNA est donc négligeable et il reste uniquement à optimiser celle de la génération de la porteuse. Cette génération de la fréquence porteuse d'oscillation, quant à elle, est une fréquence fixe adaptée à un mélangeur à un instant donné. Elle se fait par multiplication bande étroite dans une boucle à verrouillage de phase, couramment désignée par l'acronyme anglo-saxon « PLL » signifiant « Phase-Locked Loop », à partir d'un oscillateur de référence de type oscillateur à quartz. Or, le bruit de phase de l'oscillateur de référence est nettement inférieur à celui d'un CNA. Et c'est seulement ce bruit de phase de l'oscillateur de référence qui est amplifié par multiplication et qu'on retrouve à la sortie du système.

L'invention a encore pour principaux avantages qu'elle autorise une plus grande pureté spectrale. En effet, la modulation en sortie des CNA n'étant pas multipliée en fréquence, les raies parasites ne sont pas amplifiées. Par conséquent, l'invention permet de bénéficier de la pureté spectrale des CNA sans la dégrader. L'invention permet donc avantageusement de combiner la souplesse d'un générateur numérique de modulation avec une utilisation optimum des CNA en terme de bande passante et de raies parasites et avec une utilisation optimum de la transposition de fréquence par mélangeur BLU.

L'invention propose également une architecture adaptable en fonction des contraintes en performance et en coût. En effet, la sélection des CNA repose sur la bande de modulation recherchée, qui est liée à la fréquence d'échantillonnage, et sur la pureté spectrale, qui est liée à la linéarité et à la résolution. Elle permet aussi d'adapter la profondeur de la mémoire à la génération des signaux arbitraires à générer. Elle permet aussi d'adapter la pureté spectrale en fonction de la qualité de la chaîne de mesure des défauts du mélangeur, notamment en fonction de la qualité du récepteur radio-fréquence et du CAN. Elle permet aussi d'adapter le bruit de phase en fonction de la qualité de la synthèse de la fréquence porteuse.

D'autres caractéristiques et avantages de l'invention apparaîtront à l'aide de la description qui suit faite en regard de dessins annexés qui représentent :
- la figure 1, par un synoptique, une illustration d'un exemple d'architecture permettant de mettre en oeuvre un générateur de formes d'ondes selon l'invention ;
- la figure 2, par un synoptique, une illustration d'un autre exemple d'architecture permettant de mettre en oeuvre un générateur de formes d'ondes selon l'invention.

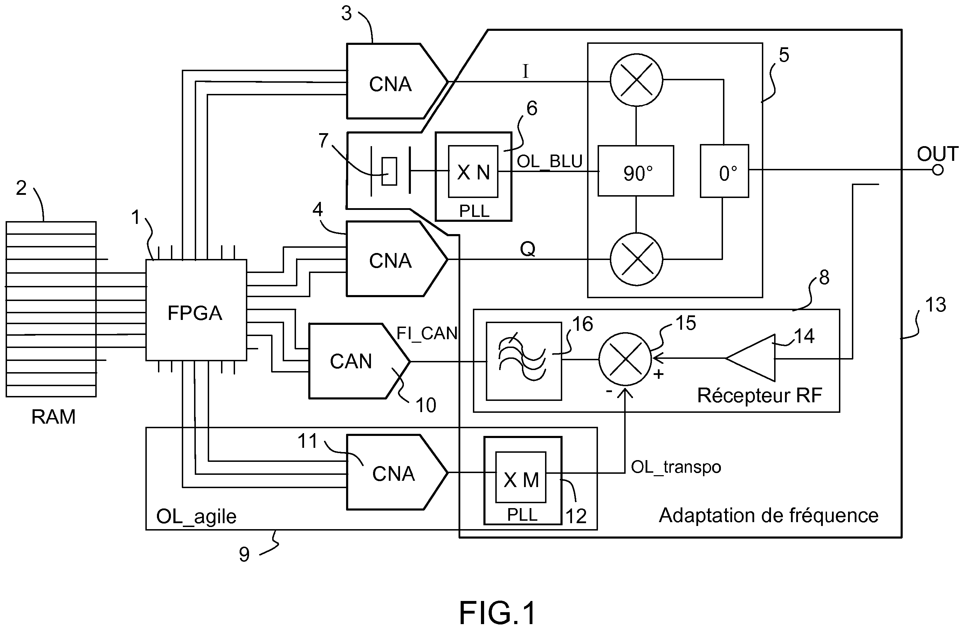

La figure 1 illustre par un synoptique un exemple d'architecture permettant de mettre en oeuvre un générateur de formes d'ondes selon l'invention. L'architecture de la figure 1 comporte par exemple un composant numérique programmable 1 du type FPGA, ainsi qu'une mémoire 2 de type RAM. Avantageusement, le FPGA 1 peut lire des formes d'ondes dans la mémoire 2, formant un générateur numérique vectoriel de formes d'ondes arbitraires. Mais il pourrait également être envisagé que le FPGA 1 utilise des opérateurs de traitement de signal numérique pour calculer des formes d'ondes. Le FPGA 1 peut par exemple fournir deux signaux numériques I et Q en quadrature, échantillonnés à très haute fréquence, supérieure à 1 gigahertz (GHz) par exemple. Les signaux numériques I et Q sont convertis en signaux analogiques par des CNA 3 et 4 respectivement. Les signaux analogiques I et Q sont délivrés sur les entrées de fréquences intermédiaires larges bandes d'un mélangeur BLU 5. Par exemple, les signaux analogiques en entrée du mélangeur 5 sont des signaux de type vidéofréquence à couplage continu. Le mélangeur 5 fournit en sortie un signal radiofréquence OUT, en faisant par exemple une transposition vectorielle de fréquence autour d'une fréquence porteuse OL_BLU, qui peut avantageusement être fournie à son entrée OL par un oscillateur local formé par un pilote à quartz 7 et une PLL 6 de facteur de multiplication N ajustable par exemple. Ce faisant, le mélangeur 5 introduit dans le signal OUT des défauts de conversion, à savoir une fuite OL, une raie image et des raies d'intermodulation essentiellement d'ordre 2 et 3. Un dispositif de mesure comportant notamment un récepteur radiofréquence 8, un oscillateur local agile de transposition 9 et un CAN 10, permet de mesurer précisément ces défauts introduits par le mélangeur 5. Le récepteur radiofréquence 8 peut avantageusement être choisi pour offrir une linéarité élevée, une dynamique élevée et un rapport signal à bruit élevé. Dans le cas présent, le récepteur 8 peut être considéré à linéarité élevée si son point d'intermodulation d'ordre 3 spécifié en entrée, couramment désigné IP3, selon l'acronyme anglo-saxon « third order input intercept point », est supérieur à +20 décibels milliwatt (dBm). Le récepteur 8 peut ici être considéré à dynamique élevée si son point de compression à 1 dB ramené en entrée est supérieur à 0 dBm. Quant au rapport signal à bruit, il quantifie ici la dynamique utilisable entre le signal utile à l'entrée du CAN 10 et le bruit plancher de la mesure dans la bande de mesure. Dans la cas présent, il peut être considéré élevé s'il est supérieur à 60dB dans une bande de mesure de 30MHz. Le dispositif de mesure ainsi formé constitue alors un récepteur hétérodyne linéaire en amplitude, à faible bande et à très forte dynamique de mesure. La dynamique de mesure du récepteur repose notamment sur l'utilisation du CAN 10, dont la fréquence d'échantillonnage est avantageusement plus faible que celle des CNA 3 et 4, mais qui offre une plus forte résolution d'amplitude. L'oscillateur local agile de transposition 9 peut par exemple être commandé par un oscillateur à commande numérique implémenté dans le FPGA 1, dont une sortie numérique est convertie en analogique par un CNA 11 puis avantageusement multipliée en fréquence par un facteur M dans une PLL 12. En permettant de sélectionner une fréquence centrale OL_transpo qui dépend du facteur M et de la fréquence du signal synthétisé à la sortie du CNA 11, l'oscillateur local agile de transposition 9 peut avantageusement permettre de choisir la sous bande de fréquence à analyser en sortie OUT. L'analyse est ensuite faite par traitement numérique dans le FPGA 1 sur les échantillons convertis grâce au CAN 10. Le traitement numérique élabore des coefficients de pre-distortion. Ces coefficients sont appliqués par des correcteurs numériques positionnés sur le trajet des signaux numériques portant l'information de modulation, avant conversion par les CNA 3 et 4, dans le FPGA 1. Le dispositif ainsi décrit permet d'effectuer des corrections de type compensation ou asservissement.

Il faut bien comprendre que seule une partie 13 de l'architecture nécessite une adaptation suite à un changement de fréquence porteuse OL_BLU. Avantageusement, il peut s'agir de modifier la fréquence OL_BLU en agissant sur le taux N de multiplication de la PLL 6 ou même en substituant un autre oscillateur au pilote à quartz 7 si besoin. Il peut également s'agir de faire évoluer le récepteur 8, qui peut comporter par exemple un amplificateur 14, un mélangeur 15 et un filtre passe-bande 16. A fréquence OL_BLU fixe, le filtre passe-bande 16 permet par exemple de sélectionner une sous-bande et d'améliorer le rapport signal à bruit de la mesure. Avantageusement, la génération des signaux de modulation 1 et Q ne nécessite aucune adaptation suite à un changement de fréquence porteuse OL_BLU. L'annulation de la fuite OL peut être réalisée par une boucle d'asservissement alimentée par les mesures de la chaîne de retour incluant le récepteur 8. Les corrections peuvent être appliquées dans le FPGA 1, avant conversion analogique dans les CNA 3 et 4. La raie image peut être compensée ponctuellement en fonction des formes d'ondes et de l'environnement du système en termes de variation de fréquence et de température. Le système possédant une très forte dynamique de mesure grâce au récepteur 8 et au CAN 10, les raies d'intermodulation souvent faibles peuvent être mesurées et compensées par des techniques proches de celles utilisées pour la raie image.

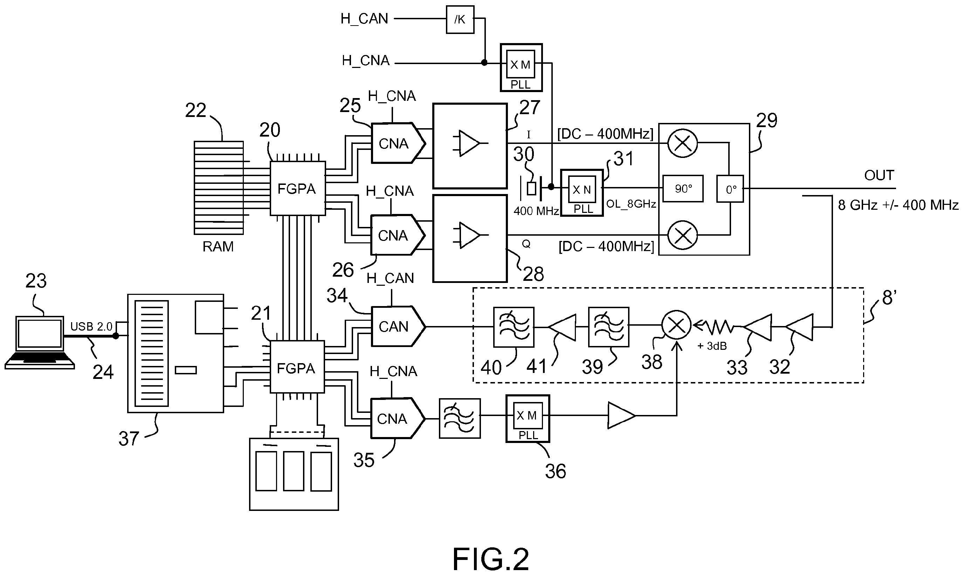

La figure 2 illustre par un synoptique un autre exemple d'architecture permettant de mettre en oeuvre un générateur de formes d'ondes selon l'invention. Dans la figure 2, le générateur de formes d'ondes s'articule autour de deux composants programmables 20 et 21 de type FPGA. A partir d'un oscillateur à commande numérique implémenté dans le FPGA 20, deux signaux I et Q sont générés à la sortie de deux CNA 25 et 26 respectivement. Le FPGA 20 peut lire des formes d'ondes stockées dans une mémoire 22 de type RAM. Le chargement de la mémoire 22 peut alors être réalisé à partir d'un ordinateur 23, par l'intermédiaire d'une liaison filaire 24 de type USB, d'une carte microcontrôleur 37 et du FPGA 21 par exemple. Le FPGA 20 prend en charge le synchronisme entre les échantillons I et Q envoyés aux CNA 25 et 26 afin d'assurer la parfaite quadrature des signaux convertis. Les CNA 25 et 26 sont des modèles très rapides, avec une fréquence de conversion H_CNA de l'ordre de 1200 mégabits par seconde (Mbps) et une résolution sur l'amplitude de 14 bits, comme par exemple les modèles portant la référence AD9736 fabriqués par la société ANALOG DEVICES. Dans le mode de réalisation de la figure 2, les CNA 25 et 26 sont respectivement associés à des étages vidéofréquences différentiels transimpédances 27 et 28 à couplage continu, offrant une très large bande de l'ordre de 400 MHz. Dans ce mode de réalisation, la fonction des étages vidéofréquences transimpédances 27 et 28 est d'abord d'assurer la conversion des sorties en courant des CNA 25 et 26 respectivement, en tensions sur charge adaptées aux entrées vidéofréquences d'un mélangeur BLU 29. La fonction des étages vidéofréquences transimpédances 27 et 28 est également d'assurer le filtrage anti-repliement lié à la conversion numérique vers analogique des signaux I et Q. La fonction des étages vidéo transimpédances 27 et 28 est aussi d'assurer le couplage depuis le continu jusqu'à l'extrémité de la bande de Nyquist entre les étages de sortie respectifs des CNA 25 et 26 et l'entrée du mélangeur 29. Les étages vidéofréquences 27 et 28 peuvent être réalisés autour d'un amplificateur opérationnel à contre-réaction en courant à très large bande, par exemple un amplificateur de référence THS3202 fabriqué par la société TEXAS INSTRUMENTS.

La partie d'adaptation de fréquence comporte notamment le mélangeur BLU 29, qui est du modèle HMC526LC4 fabriqué sous la marque HITTITE. Il appartient à une famille de mélangeurs couvrant une gamme de fréquences allant de quelques gigahertz jusqu'à plus de 20 GHz. Il dispose d'une bande passante sur ses entrées vidéofréquences de l'ordre de 3,5 GHz. En sortie du mélangeur 29, le signal radiofréquence est centré autour d'une fréquence porteuse OL à 8 GHz par exemple. Cette fréquence OL est obtenue par multiplication d'un signal à 400 mégaHertz (MHz) issu d'un pilote à quartz 30. Une PLL 31 peut avantageusement assurer la multiplication. Pour obtenir une fréquence OL à 8 GHz, le taux N de multiplication de la PLL 31 peut par exemple être ajusté à une valeur de 20. Mais ce taux N peut être ajusté de façon dynamique par incrément de 1, de sorte à obtenir des pas de 400 MHz en agilité de fréquence. La bande disponible à la sortie de chacun des deux étages vidéo 27 et 28 peut être de l'ordre de 400 MHz, de sorte que la bande instantanée radiofréquence disponible à la sortie du mélangeur 29 peut être de 800 MHz centré sur la fréquence OL à 8 GHz. La bande instantanée correspond alors à deux pas d'agilité de la synthèse de fréquence OL, ce qui permet de balayer continûment une très large bande de fréquence.

Un dispositif de mesure 8' peut par exemple comporter deux amplificateurs 32 et 33 à faible facteur de bruit, de l'ordre de 2.5 décibels (dB) par exemple. Les amplificateurs 32 et 33 sont des amplificateurs hyperfréquences de type « distribués » à large bande, s'étendant de 2 à 20 GHz par exemple, comme des amplificateurs portant la référence HMC462 fabriqués par la société HITTITE. Le dispositif de mesure 8' rend les défauts du mélangeur 29 observables à l'entrée d'un CAN 34 à 16 bits de résolution d'amplitude et ayant une fréquence de conversion H_CAN de 120 Mbps par exemple. Le CAN 34 peut par exemple être un CAN portant la référence LTC2209 fabriqué par la société LINEAR TECHNOLOGY. Le dispositif de mesure 8' transpose le signal OUT pour le rendre observable par sous-bande par le CAN 34. La transposition peut par exemple être assurée par un mélangeur radiofréquence de type HMC553 fabriqué par la société HITTITE. Le signal de transposition peut avantageusement être fourni par un oscillateur à commande numérique implémenté dans le FPGA 21, dont la sortie est convertie par un CNA 35 rapide identique aux CNA 25 et 26 puis multipliée en fréquence par une PLL 36 dont le taux de multiplication M vaut 30 par exemple.

Par ailleurs, le FPGA 21 peut élaborer, à partir des données observées dans un récepteur 8' qui est l'équivalent au récepteur 8 de la figure 1, les corrections à apporter aux signaux I et Q. Le récepteur 8' peut comporter par exemple un mélangeur 38, un amplificateur 41 et deux filtres passe-bande 39 et 40. Les corrections peuvent par exemple être appliquées par le FPGA 20 qui est connecté directement au FPGA 21.

Dans un mode de réalisation plus complexe de l'invention, il est possible d'associer plusieurs mélangeur BLU comme le mélangeur BLU 29, plusieurs dispositifs comme le dispositif de mesure 8', plusieurs PLL comme les PLL 31 et 36 et plusieurs pilotes à quartz comme le pilote 30. Pour un mélangeur et un dispositif de mesure donnés, la capacité d'agilité de la PLL associée peut être utilisée pour translater de façon continue en fréquence la bande instantanée du modulateur. Concrètement, dans le cas de la figure 2, la PLL 31 multiplie par 20 la fréquence issue du pilote à quartz 30 à 400 MHz. Le générateur de modulation dispose d'une bande instantanée de 800 MHz. En programmant par pas de 2 le taux de division de la PLL 31, la fréquence porteuse évolue par pas de 800 MHz. Pour chaque pas de 800 MHz ainsi réalisé, le modulateur procure une bande instantanée de 800 MHz. Le dispositif permet donc de couvrir continûment en fréquence une large bande de fréquence, dans la limite du fonctionnement de la PLL 31, du mélangeur BLU 29, du dispositif de mesure 8' et de la PLL 36. Dès que les limites pratiques de ces éléments sont atteintes, il est possible d'associer le générateur de modulation à un autre mélangeur et à un autre dispositif de mesure centrés sur les bandes d'agilités adjacentes. La couverture continue en fréquence d'un tel dispositif peut avoisiner plusieurs gigahertz.

L'invention a encore pour principaux avantages qu'elle permet de mesurer avec une très grande dynamique les sous-bandes de fréquence du signal analogique modulé. Elle permet également l'implémentation dans le module numérique de traitements d'auto-calibrage permettant de corriger en boucle fermée d'asservissement les défauts introduits par le mélangeur pour adapter la fréquence, à savoir la fuite OL, la raie image et les raies d'intermodulation. En effet, le module numérique de calcul selon l'invention permet d'annuler la fuite OL, d'annuler la raie image et permet de traiter les raies d'intermodulation du mélangeur, de manière à encore améliorer la pureté spectrale. Mais ces traitements d'auto-calibrage font l'objet d'une autre demande de brevet déposée par la demanderesse.

## Revendications

1. Dispositif permettant de moduler un signal analogique dans une large bande de fréquence à partir d'un signal numérique de modulation, le dispositif comportant, disposés en boucle fermée :
- un mélangeur (5) à bande latérale unique fournissant en sortie le signal analogique modulé (OUT) ;
- un récepteur radio-fréquences (8) recevant en entrée le signal analogique modulé (OUT) de retour de boucle ;
- un convertisseur analogique-numérique (10) recevant en entrée la sortie analogique du récepteur radio-fréquences ;
- un module numérique de calcul (1) recevant en entrée le signal numérique de modulation et la sortie numérique du convertisseur analogique-numérique (10), ledit module (1) calculant des signaux numériques qu'il fournit en entrée de convertisseurs numérique-analogiques (3, 4), chacun desdits convertisseurs fournissant un signal analogique à l'une des entrées du mélangeur (5), lesdits signaux numériques étant calculés de sorte à corriger les écarts introduits par le mélangeur (5) dans le signal analogique modulé par rapport au signal numérique de modulation ;
le dispositif étant **caractérisé en ce qu'**il comporte des moyens (9) pour transposer le signal analogique modulé dans la bande de mesure du convertisseur analogique-numérique (10) par sous-bandes de fréquence, lesdits moyens (9) comportant une boucle à verrouillage de phase (12) dont le taux de multiplication (M) est ajustable, permettant de sélectionner une sous bande de fréquence en sélectionnant sa fréquence centrale (OL_transpo), de sorte que le convertisseur analogique-numérique (10) mesure les écarts introduits par le mélangeur (5) quelle que soit la gamme de fréquence dans laquelle le signal analogique est modulé.

2. Dispositif selon la revendication 1, **caractérisé en ce que** chacun des convertisseurs numérique-analogiques (3, 4) fournit un signal analogique à l'une des entrées du mélangeur (5) par l'intermédiaire d'un étage analogique vidéofréquence (27, 28).

3. Dispositif selon la revendication 1, **caractérisé en ce que** la fréquence d'échantillonnage du convertisseur analogique-numérique (10) est inférieure ou égale à la fréquence d'échantillonnage des convertisseurs numérique-analogiques (3, 4), de sorte que le convertisseur analogique-numérique (10) mesure, dans une sous-bande de fréquence donnée, une fuite d'oscillateur local et/ou une raie image et/ou des raies d'intermodulation introduites par le mélangeur (5).

4. Dispositif selon la revendication 1, **caractérisé en ce que** l'entrée OL du mélangeur (5) est alimentée par une boucle à verrouillage de phase (6) dont le taux de multiplication (N) est ajustable, permettant de sélectionner une fréquence porteuse (OL_BLU) du signal analogique modulé.

5. Dispositif selon la revendication 1, **caractérisé en ce que** le récepteur radio-fréquence (8) comporte au moins un filtre passe-bande (16), permettant au convertisseur analogique-numérique (10) de mesurer une sous-bande de fréquence du signal analogique modulé.

6. Dispositif selon la revendication 1, **caractérisé en ce que** les signaux (I, Q) en entrée du mélangeur (5) sont des signaux vidéofréquences en quadrature à couplage continu.

7. Dispositif selon la revendication 1, **caractérisé en ce que** les signaux (I, Q) en entrée du mélangeur (5) ne dépendent pas de la sous-bande de fréquence sélectionnée à un instant donné.

8. Dispositif selon la revendication 1, **caractérisé en ce que** le module numérique de calcul est implémenté dans un FPGA (1) qui lit le signal numérique de modulation dans une mémoire (2), de sorte que le dispositif peut générer des formes d'ondes arbitraires.

9. Dispositif selon la revendication 1, **caractérisé en ce que** le module numérique de calcul est implémenté dans un FPGA (1) qui calcule le signal numérique de modulation en utilisant des opérateurs de traitement de signal numérique.

10. Dispositif selon la revendication 1, **caractérisé en ce que** les moyens (9) pour transposer le signal analogique modulé sont commandés par le module numérique de calcul (1).

## Patentansprüche

1. Vorrichtung zum Modulieren eines analogen Signals in einem breiten Frequenzband auf der Basis eines digitalen Modulationssignals, wobei die Vorrichtung Folgendes in einer geschlossene Schleife angeordnet umfasst:
- einen Mischer (5) mit einem einzigen Seitenband, der am Ausgang das modulierte analoge Signal (OUT) bereitstellt;
- einen Funkfrequenzempfänger (8), der am Eingang das modulierte analoge Schleifenrückkopplungssignal (OUT) empfängt;
- einen Analog-Digital-Wandler (10), der am Eingang den analogen Ausgang des Funkfrequenzempfängers empfängt;
- ein digitales Rechenmodul (1), das am Eingang das digitale Modulationssignal und den digitalen Ausgang des Analog-Digital-Wandlers (10) empfängt, wobei das Modul (1) die digitalen Signale berechnet, die es an den Eingang von Digital-Analog-Wandlern (3, 4) anlegt, wobei jeder der Wandler ein analoges Signal an einen der Eingänge des Mischers (5) anlegt, wobei die digitalen Signale berechnet werden, um die vom Mischer (5) in dem modulierten analogen Signal mit Bezug auf das digitale Modulationssignal eingeführten Abweichungen zu korrigieren;
wobei die Vorrichtung **dadurch gekennzeichnet ist, dass** sie Mittel (9) zum Transponieren des modulierten analogen Signals in dem Messband des Analog-Digital-Wandlers (10) durch Frequenzsubbänder umfasst, wobei die Mittel (9) eine Phasenregelschleife (12) umfassen, deren Multiplikationsrate (M) justierbar ist, so dass ein Frequenzsubband durch Wählen seiner Mittenfrequenz (OL_transpo) gewählt werden kann, so dass der Analog-Digital-Wandler (10) die von dem Mischer (5) eingeführten Abweichungen misst, unabhängig von dem Frequenzbereich, in dem das analoge Signal moduliert ist.

2. Vorrichtung nach Anspruch 1, **dadurch gekennzeichnet, dass** jeder der Digital-Analog-Wandler (3, 4) ein analoges Signal an einen der Eingänge des Mischers (5) mittels einer analogen Videofrequenzstufe (27, 28) anlegt.

3. Vorrichtung nach Anspruch 1, **dadurch gekennzeichnet, dass** die Abtastfrequenz des Analog-Digital-Wandlers (10) gleich oder kleiner ist als die Abtastfrequenz der Digital-Analog-Wandler (3, 4), so dass der Analog-Digital-Wandler (10) in einem gegebenen Frequenzsubband ein Lokaloszillatorleckage und/oder eine Bildlinie und/oder von dem Mischer (5) eingeführte Intermodulationslinien misst.

4. Vorrichtung nach Anspruch 1, **dadurch gekennzeichnet, dass** der Eingang OL des Mischers (5) von einer Phasenregelschleife (6) gespeist wird, deren Multiplikationsrate (N) justierbar ist, so dass eine Trägerfrequenz (OL_BLU) des modulierten analogen Signals gewählt werden kann.

5. Vorrichtung nach Anspruch 1, **dadurch gekennzeichnet, dass** der Funkfrequenzempfänger (8) wenigstens ein Bandpassfilter (16) umfasst, das es dem Analog-Digital-Wandler (10) gestattet, ein Frequenzsubband des modulierten analogen Signals zu messen.

6. Vorrichtung nach Anspruch 1, **dadurch gekennzeichnet, dass** die Signale (I, Q) am Eingang des Mischers (5) DC-gekoppelte Quadratur-Videofrequenzsignale sind.

7. Vorrichtung nach Anspruch 1, **dadurch gekennzeichnet, dass** die Signale (I, Q) am Eingang des Mischers (5) nicht von dem zu einem gegebenen Zeitpunkt gewählten Frequenzsubband abhängig sind.

8. Vorrichtung nach Anspruch 1, **dadurch gekennzeichnet, dass** das digitale Rechenmodul in einer FPGA (1) implementiert wird, die das digitale Modulationssignal in einem Speicher (2) liest, so dass die Vorrichtung willkürliche Wellenformen erzeugen kann.

9. Vorrichtung nach Anspruch 1, **dadurch gekennzeichnet, dass** das digitale Rechenmodul in einer FPGA (1) implementiert wird, die das digitale Modulationssignal unter Verwendung von Digitalsignalverarbeitungsoperatoren berechnet.

10. Vorrichtung nach Anspruch 1, **dadurch gekennzeichnet, dass** die Mittel (9) zum Transponieren des modulierten analogen Signals von dem digitalen Rechenmodul (1) gesteuert werden.

## Claims

1. A device that makes it possible to modulate an analogue signal in a wide frequency band from a digital modulation signal, the device comprising, arranged in a closed loop:
- a single lateral band mixer (5) delivering at the output the modulated analogue signal (OUT);
- a radio frequency receiver (8) receiving at the input the modulated analogue loop feedback signal (OUT);
- an analogue to digital converter (10) receiving at the input the analogue output of the radio frequency receiver;
- a digital calculation module (1) receiving at the input the digital modulation signal and the digital output of the analogue to digital converter (10), said module (1) calculating the digital signals that it delivers at the input of the digital to analogue converters (3, 4), each of said convertors delivering an analogue signal to one of the inputs of the mixer (5), said digital signals being calculated such as to correct the deviations introduced by the mixer (5) in the modulated analogue signal in relation to the digital modulation signal;
the device being **characterised in that** it comprises means (9) for transposing the modulated analogue signal in the measurement band of the analogue to digital converter (10) by frequency sub-bands, said means (9) comprising a phase locked loop (12) of which the multiplication rate (M) is adjustable, and this makes it possible to select a frequency sub-band by selecting its central frequency (LO_transpo) such that the analogue to digital converter (10) measures the deviations introduced by the mixer (5), whatever the frequency range in which the analogue signal is modulated.

2. The device according to Claim 1, **characterised in that** each of the digital to analogue converters (3, 4) delivers an analogue signal to one of the inputs of the mixer (5) by means of a video frequency analogue stage (27, 28).

3. The device according to Claim 1, **characterised in that** the sampling frequency of the analogue to digital converter (10) is less than or equal to the sampling frequency of the digital to analogue converters (3, 4), such that the analogue to digital converter (10) measures, in a given frequency sub-band, a local oscillator leakage and/or an image line and/or intermodulation lines introduced by the mixer (5).

4. The device according to Claim 1, **characterised in that** the input LO of the mixer (5) is fed by a phase locked loop (6) of which the multiplication rate (N) is adjustable, and this makes it possible to select a carrier frequency (LO_SLB) of the modulated analogue signal.

5. The device according to Claim 1, **characterised in that** the radio frequency receiver (8) comprises at least one bandpass filter (16) which enables the analogue to digital converter (10) to measure a frequency sub-band of the modulated analogue signal.

6. The device according to Claim 1, **characterised in that** the signals (I, Q) at the input of the mixer (5) are quadrature video frequency signals with continuous coupling.

7. The device according to Claim 1, **characterised in that** the signals (I, Q) at the input of the mixer (5) are not dependent upon the frequency sub-band selected at a given time.

8. The device according to Claim 1, **characterised in that** the digital calculation module is implemented in an FPGA (1) which reads the digital modulation signal in a memory (2) such that the device can generate arbitrary waveforms.

9. The device according to Claim 1, **characterised in that** the digital calculation module is implemented in an FPGA (1) which calculates the digital modulation signal by using digital signal processing operators.

10. The device according to Claim 1, **characterised in that** the means (9) for transposing the modulated analogue signal are controlled by the digital calculation module (1).
